# EUROPÄISCHE PATENTSCHRIFT

(11) **EP 3 186 862 B1**
(45) Veröffentlichungstag und Bekanntmachung des Hinweises auf die Patenterteilung: **18.08.2021**
(21) Anmeldenummer: 15739569.0
(22) Anmeldetag: 16.07.2015
(51) Int. Cl.: H02G 3/12, H05K 7/14

(54) **AUTOMATISIERUNGSMODUL FÜR DIE GEBÄUDEAUTOMATION**
AUTOMATION MODULE FOR BUILDING AUTOMATION
MODULE D'AUTOMATISATION POUR LA DOMOTIQUE

(30) Priorität: 26.08.2014 CH 12742014
(43) Veröffentlichungstag der Anmeldung: 05.07.2017
(73) Patentinhaber: Obrist, Werner, 8633 Wolfhausen (CH)
(72) Erfinder: Obrist, Werner, 8633 Wolfhausen (CH)
(74) Vertreter: Rutz, Andrea
(86) Internationale Anmeldenummer: PCT/EP2015/066337
(87) Internationale Veröffentlichungsnummer: WO 2016/030082

(56) Entgegenhaltungen:
- EP-A1- 2 093 852
- DE-U1- 29 904 984
- DE-U1-202011 109 874
- FR-A1- 2 925 257
- US-A1- 2010 020 580

## Beschreibung

### TECHNISCHES GEBIET

Die vorliegende Erfindung betrifft ein zum zumindest teilweisen Unterputzeinbau in einer Hauswand ausgelegtes Automatisierungsmodul für die Gebäudeautomation sowie eine Gebäudeautomationsvorrichtung mit einem derartigen Automatisierungsmodul.

### STAND DER TECHNIK

Diverse Systeme für Hausautomationslösungen sind auf dem Markt erhältlich. Die meisten dieser Systeme haben eine sternförmige Struktur mit einer zum Beispiel im Keller angeordneten Zentraleinheit. Die verschiedenen Aktoren und Sensoren werden dabei drahtgebunden oder kabellos, zum Beispiel via Funk, mit der Zentraleinheit verbunden. Die Zentraleinheit nimmt die Signale von den Sensoren entgegen, verarbeitet diese und steuert entsprechend die Aktoren an. Als Sensoren kommen zum Beispiel Bewegungsmelder, Temperaturfühler, Feuchtefühler, CO₂-Fühler, Regen- oder Windsensoren oder Lichtsensoren in Frage. Via die Aktoren oder Schaltelemente, bei denen es sich beispielsweise um Relaisschalter oder Dimmer handeln kann, werden Verbraucher, wie insbesondere die Beleuchtung, die Heizung und/oder Rollläden, zeit- und bedarfsgerecht gesteuert. Es können aber zum Beispiel auch Lüftungssysteme, Alarmanlagen oder beliebige Haushaltsgeräte, wie Kaffeemaschinen oder Radios, an der Zentraleinheit angeschlossen sein und von dieser gesteuert werden.

Bei einem drahtgebundenen derartigen System mit sternförmiger Struktur ist der Installationsaufwand nicht nur bei einer nachträglichen Installation in ein bestehendes Gebäude, sondern auch bei einem Neubau aufgrund der Leitungsverlegung und der Verkabelung verhältnismässig gross.

Die kabellosen Systeme sind aufgrund des in Gebäuden üblicherweise vorhandenen Stahlbetons und weiteren Metalls in ihrer Reichweite stark begrenzt bzw. es ist der Einsatz von Repeatern notwendig, um die gewünschten Reichweiten zu erreichen. Kabellose Systeme haben deshalb einen ständigen, verhältnismässig hohen Stromverbrauch, welcher bei vielen Systemen mit Hilfe von regelmässig auszuwechselnden Batterien bewerkstelligt wird. Zudem verursachen kabellose Systeme eine gewisse Strahlenbelastung für die sich im Gebäude aufhaltenden Personen.

Neben den sternförmigen Systemen mit den oben erwähnten Nachteilen gibt es Systeme mit mehreren miteinander vernetzten, dezentralen Automatisierungsmodulen, welche in der Netzstruktur des Systems jeweils einen Knoten bilden. Ein einzelner dieser dezentralen Knoten kann jeweils mit mehreren Sensoren verbunden sein und eine Steuereinheit umfassen, welche zur Ansteuerung von einem oder mehreren Aktoren dient. Untereinander sind die einzelnen Knoten bei derartigen Systemen entweder kabelgebunden mittels eines Datenbusses oder drahtlos via Funk verbunden.

Ein Gebäudeautomationssystem mit mehreren dezentralen, aber miteinander vernetzten Knoten ist beispielsweise in der EP 2 667 680 A1 offenbart.

Bei derartigen dezentralen Systemen ist die Verkabelung wesentlich einfacher. Allerdings muss bei den Automatisierungsmodulen jeweils genügend Platz vorhanden sein, um die Aktoren sowie die Elektronik inkl. Steuereinheit unterzubringen. Da die einzelnen Automatisierungsmodule üblicherweise im Wohnbereich angeordnet sind, ist aus ästhetischen Gründen zudem eine Unterputzinstallation des Automatisierungsmoduls inkl. aller dazugehörigen elektronischen Komponenten erstrebenswert. Der Platz in bestehenden Unterputzdosen von Gebäuden ist aber in der Regel sehr eingeschränkt, so dass neben die bereits verlegten Kabel nur noch eine geringe Anzahl von Aktoren angeordnet werden kann. Das System ist dadurch entsprechend in seiner Funktion begrenzt, oder es müssen weitere Unterputzdosen verwendet werden, was nicht nur ästhetische Nachteile mit sich bringt, sondern meist auch zusätzlichen Aufwand bedeutet.

Vorrichtungen für die Gebäudeautomation, welche in Unterputzweise installiert werden, sind beispielsweise in der DE 10 2012 001 402 A1, in der DE 20 2009 000 673 U1 oder in der DE 20 2011 109 874 U1 offenbart.

In der DE 299 04 984 U1 sowie in der DE 20 2011 109 874 U1 sind Unterputzanschlussdosen zur Übertragung von Daten offenbart. Mehrere Platinen sind jeweils schichtweise übereinander angeordnet. DE 20 2011 109874 U1 offenbart ein Automatisierungsmodul für die Gebäudeautomation, welches für den zumindest teilweisen Unterputzeinbau in einer Hauswand ausgelegt ist, mit einem Isolationsbereich; umfassend eine erste Leiterplatte mit zumindest einer Eingabe-Schnittstelle; eine zweite Leiterplatte; und eine dritte Leiterplatte; wobei die erste, zweite und dritte Leiterplatte sowie der Isolationsbereich schichtweise übereinander angeordnet sind, und wobei der Isolationsbereich in Form einer Isolationsplatte ausgebildet ist.

### DARSTELLUNG DER ERFINDUNG

Es ist also eine Aufgabe der vorliegenden Erfindung, ein Automatisierungsmodul für die Gebäudeautomation anzugeben, welches einerseits möglichst kompakt und platzsparend ist, und in welchem andererseits eine möglichst grosse Anzahl von elektronischen Komponenten, wie insbesondere Aktoren, untergebracht werden können. Zur Lösung dieser Aufgabe wird ein Automatisierungsmodul vorgeschlagen, wie es in Anspruch 1 angegeben ist. Ausserdem wird in Anspruch 13 eine Gebäudeautomationsvorrichtung mit einem derartigen Automatisierungsmodul angegeben. Vorteilhafte Ausgestaltungen der Erfindung sind in den abhängigen Ansprüchen angegeben.

Die vorliegende Erfindung stellt also ein Automatisierungsmodul für die Gebäudeautomation zur Verfügung, welches für den zumindest teilweisen, bevorzugt sogar für den vollständigen Unterputzeinbau in einer Hauswand ausgelegt ist. Das Automatisierungsmodul hat einen Grossspannungsbereich und einen Kleinspannungsbereich. Das Automatisierungsmodul weist ausserdem auf
einen Isolationsbereich in Form einer Isolationsplatte zur Trennung des Grossspannungsbereichs vom Kleinspannungsbereich;
eine erste Leiterplatte mit zumindest einer Eingabe-Schnittstelle;
eine zweite Leiterplatte mit zumindest einer Steuereinheit; und
eine dritte Leiterplatte mit zumindest einem Schaltelement.

Die erste, zweite und dritte Leiterplatte sowie der Isolationsbereich sind dabei schichtweise übereinander angeordnet.

Dadurch, dass drei Leiterplatten sowie der Isolationsbereich schichtweise übereinander angeordnet sind, kann das Automatisierungsmodul äusserst kompakt und mit einer hohen Dichte an elektronischen Komponenten und insbesondere Aktoren hergestellt werden. Dank der kompakten Bauweise eignet sich das Automatisierungsmodul ideal für den Unterputzeinbau. Zum Einbau des Automatisierungsmoduls kann zum Beispiel einfach ein bestehender Lichtschalter entfernt und durch das Automatisierungsmodul ersetzt werden. Aufgrund des in der Regel zwischen den Leiterplatten angeordneten Isolationsbereiches kann eine konsequente Trennung des Kleinspannungsbereiches und des Grossspannungsbereiches erreicht werden. Die zu den jeweiligen Bereichen gehörenden elektronischen Komponenten müssen dadurch nicht einzeln voneinander isoliert werden, sondern können einfach auf einer zum entsprechenden Bereich gehörenden Leiterplatte angeordnet werden.

Im Grossspannungsbereich sind zum Beispiel elektronische Komponenten angeordnet, die für Spannungen von mehr als 50 V, insbesondere von mehr als 100 V, ausgelegt sind. Bei diesen im Grossspannungsbereich angeordneten elektronischen Komponenten handelt es sich insbesondere um Aktoren, wie zum Beispiel Relaisschalter. Im Kleinspannungsbereich sind zum Beispiel elektronische Komponenten angeordnet, welche für Spannungen von weniger als 50 V, insbesondere von weniger als 48 V ausgelegt sind. Es kann sich bei diesen für den Kleinspannungsbereich ausgelegten elektronischen Komponenten insbesondere um Tastschalter, einen Prozessor oder einen Speicherchip handeln.

Der Isolationsbereich stellt ein Bereich dar, welcher sicherstellt, dass der Grossspannungsbereich derart vom Kleinspannungsbereich getrennt ist, dass sich die im Grossspannungsbereich und die im Kleinspannungsbereich angeordneten elektronischen Komponenten nicht in unerwünschter Weise gegenseitig beeinflussen können. Der Isolationsbereich ist in Form einer Isolationsplatte ausgebildet.

Die Eingabe-Schnittstelle kann zum Beispiel als einer oder mehrere Tastschalter ausgestaltet sein und somit eine Eingabe-Schnittstelle für einen menschlichen Benutzer bilden. Auf der ersten Leiterplatte können LED's als Hintergrundbeleuchtung verwendet werden, um zum Beispiel oberhalb der Tastschalter liegende Tasten in einer beliebigen Farbe und Helligkeit zu beleuchten. Dadurch können verschiedene Designansprüche erfüllt werden. Auch können die verschiedenen Tasten selbst mit beliebigen Symbolen bedruckt oder z. B. auch geprägt etc. sein, um eine gute Übersicht der Funktionalität zu gewährleisten. Die Eingabe-Schnittstelle kann aber zum Beispiel auch als eine Taster- oder Bus-Anschlussklemme ausgebildet sein und somit eine Eingabe-Schnittstelle für eine weitere technische Einrichtung bilden, welche ihrerseits eine Schnittstelle für Eingaben eines menschlichen Benutzers aufweisen kann.

Bei der Steuereinheit handelt es sich vorzugsweise um einen Prozessor, insbesondere einen Mikroprozessor. Die Steuereinheit ist in der Regel dazu ausgelegt, Signale von der Eingabe-Schnittstelle, einem Datenbus und/oder von Sensoren, die am Automatisierungsmodul angeschlossen sind, zu verarbeiten. Die Steuereinheit ist zudem üblicherweise dazu ausgelegt, basierend auf dieser Signalverarbeitung das bzw. die Schaltelemente derart anzusteuern, dass ein bestimmter Zustand in Bezug auf die am Automationsmodul angeschlossenen Verbraucher erreicht wird.

Vorzugsweise weist die dritte Leiterplatte mehrere Schaltelemente auf. Bei den Schaltelementen handelt es sich bevorzugt um Schalter, insbesondere Relaisschalter.

Die Anordnung der unterschiedlichen elektronischen Komponenten auf verschiedenen, eigens dafür vorgesehenen Leiterplatten ist nicht nur in Bezug auf die Platzausnutzung vorteilhaft, sondern führt auch dazu, dass funktional gleich oder ähnlich wirkende elektronische Komponenten auf jeweils einer entsprechenden Leiterplatte gruppiert werden. Das Automatisierungsmodul hat dadurch einen funktional modularen Aufbau, was eine erhöhte Flexibilität und eine einfachere Anpassung des Automatisierungsmoduls an eine bestimmte Situation ermöglicht. So kann zum Beispiel die dritte Leiterplatte mit den Schaltelementen für einen bestimmten Bereich in Bezug auf die zu schaltenden Stromstärken oder Spannungen ausgelegt sein. Falls das Automatisierungsmodul in einer anderen Umgebung mit höheren oder tieferen zu schaltenden Stromstärken oder Spannungen eingesetzt werden soll, kann hierzu einfach die dritte Leiterplatte mit einer entsprechend für diese Situation ausgelegten anderen Leiterplatte ausgewechselt werden.

In einer bevorzugten Ausführungsform ist der Isolationsbereich zwischen der zweiten und der dritten Leiterplatte angeordnet. Die zweite Leiterplatte ist zudem bevorzugt zwischen der ersten Leiterplatte und dem Isolationsbereich angeordnet.

Falls der Isolationsbereich zwischen der zweiten und der dritten Leiterplatte angeordnet ist, sind die elektronischen Komponenten der zweiten und dritten Leiterplatte vorteilhaft zu einem Grossteil auf den vom Isolationsbereich abgewandten Seiten der zweiten und dritten Leiterplatte angeordnet. Der Platz kann dadurch optimal ausgenutzt werden. Ausserdem sind die elektronischen Komponenten dadurch noch besser voneinander isoliert bzw. der Isolationsbereich kann kleiner dimensioniert werden. Bevorzugt sind sogar die meisten aller elektronischen Komponenten auf einer vom Isolationsbereich abgewandten Seite einer jeweiligen Leiterplatte angeordnet.

Bevorzugt ist an der ersten oder an der zweiten Leiterplatte ein insbesondere induktiver Stromsensor angebracht. Durch die Kombination des Stromsensors mit insbesondere mehreren Schaltelementen in einem einzigen Gerät ergeben sich vielfältige Möglichkeiten bzgl. der Funktionen des Automatisierungsmoduls. Der Stromsensor weist vorteilhaft eine eigene, wenn möglich vollumfängliche elektrische Isolierung auf. Aufgrund dieser eigenen Isolierung kann der Stromsensor durch den Isolationsbereich hindurchragen. Falls der Isolationsbereich als eine Isolationsplatte ausgebildet ist, weist diese bevorzugt eine Aussparung auf, durch welche der Stromsensor hindurchragt. Der Stromsensor ist somit bevorzugt im Kleinspannungsbereich an die erste oder zweite Leiterplatte angeschlossen, ragt aber durch den Isolationsbereich in den Grossspannungsbereich hinein, um vorteilhaft dort den Stromverbrauch der am Automatisierungsmodul angeschlossenen Verbraucher zu messen.

Auf der zweiten Leiterplatte ist bevorzugt zumindest eine Service- und/oder Programmierschnittstelle vorgesehen. Um einen Zugang zu dieser Service- bzw. Programmierschnittstelle zu ermöglichen, weist die erste Leiterplatte zumindest eine durchgehende Zugangsöffnung auf, welche vorteilhaft unmittelbar vor der Service- bzw. Programmierschnittstelle angeordnet ist. Dadurch, dass die Service- bzw. Programmierschnittstelle nicht auf der üblicherweise zuvorderst angeordneten ersten Leiterplatte angebracht ist, ist sie für eine sachunkundige Person weitgehend verborgen und dadurch vor unerwünschten Manipulationen geschützt.

Vorteilhaft sind die erste, zweite und dritte Leiterplatte jeweils mittels entsprechend vorgesehener elektrischer Steckverbindungen miteinander verbunden. Mittels Lösen dieser elektrischen Steckverbindungen sind die erste, zweite und dritte Leiterplatte bevorzugt jeweils zerstörungsfrei voneinander trennbar. Die Leiterplatten des Automatisierungsmoduls können dadurch leicht auseinandergenommen und wieder zusammengesetzt werden.

Bevorzugt ist auf der ersten, zweiten oder dritten Leiterplatte, insbesondere auf der ersten Leiterplatte, ein Anschluss für einen Datenbus vorgesehen, welcher zur Vernetzung von mehreren Automatisierungsmodulen dient. Vorzugsweise weist eine der Leiterplatten, insbesondere die erste Leiterplatte, zudem einen oder mehrere HLK (Heizung, Lüftung, Klima)-Anschlüsse auf, um entsprechende Signale empfangen bzw. versenden zu können. Zur Vernetzung von mehreren Automatisierungsmodulen reicht es in einer bevorzugten Ausführungsform grundsätzlich aus, die Automatisierungsmodule zum Beispiel mittels eines vieradrigen Kabels miteinander zu verbinden. Der Installationsaufwand ist somit verhältnismässig gering.

Eine besonders kompakte und platzsparende Bauweise sowie eine gleichzeitig verhältnismässig einfache und kostengünstige Herstellung des Automatisierungsmoduls wird erreicht, wenn die erste, zweite und dritte Leiterplatte sowie, falls vorhanden, vorteilhaft auch die Isolationsplatte jeweils im Wesentlichen eine achteckige Form haben.

Bevorzugterweise sind die erste, zweite und dritte Leiterplatte sowie, falls vorhanden, die Isolationsplatte von einem Gehäuse mit einer durchgehenden Gehäuseöffnung seitlich umgeben, wobei das Gehäuse vorzugsweise eine achteckige Form hat. Mittels eines solchen Gehäuses werden die darin befindlichen Leiterplatten sowie deren elektronische Komponenten optimal geschützt.

Das Gehäuse wird vorteilhaft durch eine Seitenwand gebildet, welche eine durch das Gehäuse hindurchgehende Gehäuseöffnung begrenzt. Aufgrund der durchgehenden Gehäuseöffnung weist das Gehäuse eine obere Gehäuseöffnung auf einer Seite sowie eine untere Gehäuseöffnung auf der dazu entgegengesetzten Seite auf. Das Gehäuse kann also die Form eines beidseitig offenen, vorzugsweise achteckig ausgebildeten Rohrs aufweisen. Die Platten können darin beispielsweise derart angeordnet sein, dass die erste Leiterplatte im Bereich der oberen Gehäuseöffnung und die dritte Leiterplatte im Bereich der unteren Gehäuseöffnung zu liegen kommen, wobei sich die zweite Leiterplatte sowie, falls vorhanden, die Isolationsplatte im Bereich zwischen den beiden Gehäuseöffnungen befinden.

Die dritte Leiterplatte kann einen grösseren Durchmesser aufweisen als die erste und zweite Leiterplatte sowie, falls vorhanden, die Isolationsplatte.

Vorteilhafterweise weist das Gehäuse im Bereich der dritten Leiterplatte eine Nut auf, welche sich auf einer Innenseite des Gehäuses entlang einer Umfangsrichtung des Gehäuses erstreckt und zur Aufnahme der dritten Leiterplatte dient.

Die dritte Leiterplatte wird vorzugsweise in radialer Richtung zumindest teilweise, vorteilhaft vollständig von der Nut umschlossen. Vorzugsweise ist die Nut derart ausgestaltet, dass sie den Bereich der dritten Leiterplatte, um welchen die dritte Leiterplatte grösser ist als die erste und zweite Leiterplatte sowie, falls vorhanden, die Isolationsplatte, vollständig aufnimmt. Aufgrund des grösseren Durchmessers der dritten Leiterplatte hat diese einen überstehenden äusseren Bereich, mit welchem die dritte Leiterplatte in die Nut eingesetzt werden kann. Das Gehäuse kann bevorzugt mittels der dritten Leiterplatte im Bereich seiner unteren Gehäuseöffnung abgeschlossen werden. Mittels der Nut kann die dritte Leiterplatte also im Gehäuse aufgenommen werden. Vorteilhaft ist das Gehäuse mittels der dritten Leiterplatte fixierbar und insbesondere zwischen der dritten Leiterplatte und einer weiteren Platte, wie insbesondere einem Anschlussblech, einklemmbar.

Vorteilhaft ist im Grossspannungsbereich, insbesondere auf der dritten Leiterplatte, ein Temperatursensor vorgesehen. Dieser kann insbesondere dazu dienen, bei Erreichen eines bestimmten Grenzwertes eine Not-Abschaltung der an das Automatisierungsmodul angeschlossenen Verbraucher auszulösen.

Erfindungsgemäss wird ausserdem eine Gebäudeautomationsvorrichtung angegeben, welche zumindest ein wie oben ausgeführt ausgebildetes Automatisierungsmodul aufweist. Bevorzugt weist die Gebäudeautomationsvorrichtung sogar mehrere derartige Automatisierungsmodule auf, welche miteinander vernetzt sind.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine perspektivische Explosionsansicht eines erfindungsgemässen Automatisierungsmoduls, aus darstellerischen Gründen mit weggelassenem Gehäuse und nur teilweise gezeigten elektronischen Komponenten;
- Fig. 2: eine Schnittansicht durch das Automatisierungsmodul der Fig. 1;
- Fig. 3: eine perspektivische Ansicht des Gehäuses des Automatisierungsmoduls der Fig. 1;
- Fig. 4a: eine Draufsicht von vorne auf eine erste Ausführungsform der ersten Leiterplatte des Automatisierungsmoduls der Fig. 1;
- Fig. 4b: eine Draufsicht von vorne auf eine zweite Ausführungsform der ersten Leiterplatte des Automatisierungsmoduls der Fig. 1;
- Fig. 5: eine Draufsicht von vorne auf die zweite Leiterplatte des Automatisierungsmoduls der Fig. 1;
- Fig. 6: eine Draufsicht von vorne auf die Isolationsplatte des Automatisierungsmoduls der Fig. 1; sowie
- Fig. 7: eine Draufsicht von vorne auf die dritte Leiterplatte des Automatisierungsmoduls der Fig. 1.

### BESCHREIBUNG BEVORZUGTER AUSFÜHRUNGSFORMEN

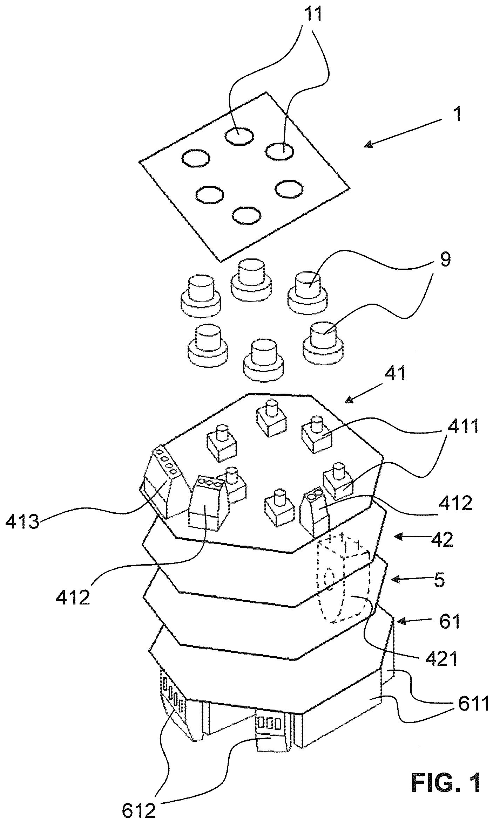

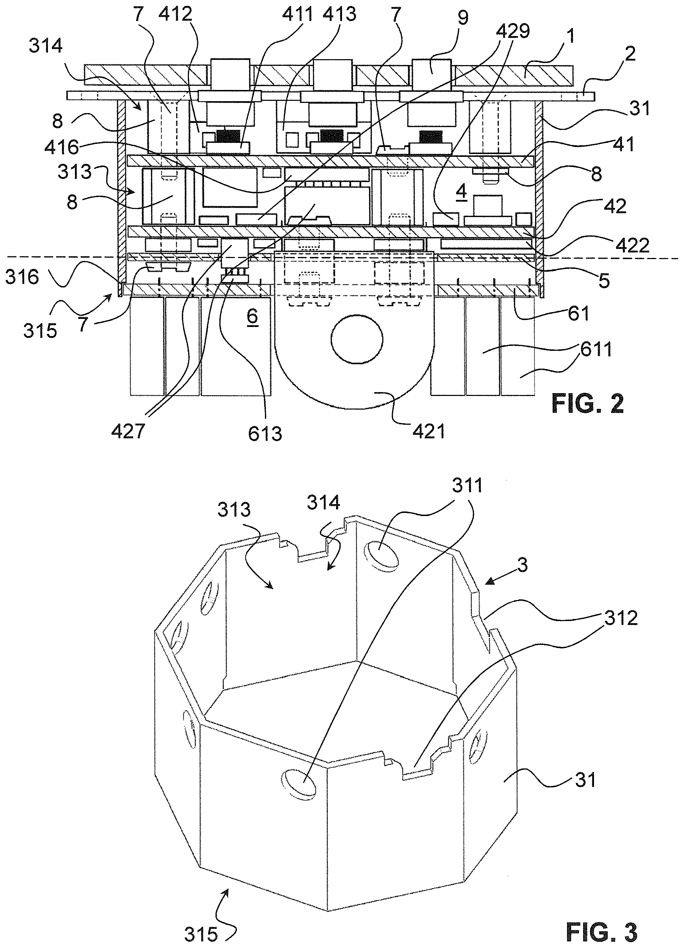

In den Figuren 1 bis 7 ist ein erfindungsgemässes Automatisierungsmodul für die Gebäudeautomation gemäss einer bevorzugten Ausführungsform gezeigt. Das Automatisierungsmodul weist eine erste Leiterplatte 41 bzw. 41', eine zweite Leiterplatte 42, eine Isolationsplatte 5 sowie eine dritte Leiterplatte 61 auf, welche schichtweise übereinander angeordnet sind. Die Isolationsplatte 5 bildet einen Isolationsbereich des Automatisierungsmoduls, der zur Trennung eines Grossspannungsbereiches 6 und eines Kleinspannungsbereiches 4 dient. Der Trennungsbereich ist in der Figur 2 mit einer gestrichelten Linie gekennzeichnet. Zum Kleinspannungsbereich 4 gehören die erste und die zweite Leiterplatte 41 und 42 und zum Grossspannungsbereich 6 die dritte Leiterplatte 61. Das gesamte Automatisierungsmodul ist für den vollständigen Unterputzeinbau in einer in den Figuren nicht dargestellten Hauswand ausgelegt.

Sowohl die erste, zweite und dritte Leiterplatte 41, 42 und 61 als auch die Isolationsplatte 5 haben jeweils im Wesentlichen eine regelmässige achteckige Form und sind alle mit derselben Orientierung übereinander angeordnet. Alle vier Platten 41, 42, 61 und 5 sind in einem Gehäuse 3 aufgenommen, welches eine Seitenwand 31 mit einer entsprechenden achteckigen Form aufweist (siehe Figuren 2 und 3). Die Seitenwand 31 umgibt jede der Platten 41, 42, 61 und 5 vollständig. Dabei definiert die Seitenwand 31 ein beidseitig offenes Gehäuse 3 mit einer durchgehenden Gehäuseöffnung 313, innerhalb welcher die Platten 41, 42, 61 und 5 angeordnet sind. Aus der Figur 2 ist gut ersichtlich, dass das Automatisierungsmodul insgesamt eine äusserst kompakte und platzsparende Ausgestaltung hat. Das Automatisierungsmodul weist eine grosse Anzahl von elektronischen Komponenten auf, welche auf einem sehr engen Raum untergebracht sind. Das ganze Automatisierungsmodul passt in eine einzelne Unterputzdose (in den Figuren nicht dargestellt), wie sie standardmässig in Gebäuden vorkommt.

Die erste Leiterplatte 41, die zweite Leiterplatte 42, die Isolationsplatte 5 sowie eine dritte Leiterplatte 61 sind mittels Schrauben 7 und Gewindehülsen 8 miteinander verbunden. Die Gewindehülsen 8 dienen auch als Distanzhülsen, um die Abstände der Platten 41, 42, 5 und 61 relativ zueinander festzulegen. Die Schrauben 7 und Gewindehülsen 8 sind vorteilhaft aus einem elektrisch nicht leitenden Kunststoffmaterial hergestellt, um die elektrische Isolation zwischen den Platten 41, 42, 5 und 61 sicherzustellen.

Die erste und dritte Leiterplatte 41 bzw. 61 sind via elektrische Steckverbindungen zwischen Verbindungssteckern 416, 613 und Verbindungsbuchsen 427 mit der zweiten Leiterplatte 42 verbunden. Mittels lösen der Schrauben 7 und Auseinanderziehen der elektrischen Steckverbindungen 416, 613 und 427 sind die Platten 41, 42, 5 und 61 zerstörungsfrei voneinander trennbar, was beispielsweise für allfällige Reparaturarbeiten vorteilhaft sein kann.

Das Automatisierungsmodul wird mittels eines Anschlussbleches 2 an einer Hauswand bzw. an einer in der Hauswand angebrachten Unterputzdose befestigt. Das Anschlussblech 2 liegt dabei auf der Wandoberfläche auf und wird mittels Schrauben in der Hauswand oder der Unterputzdose festgeschraubt. Am Anschlussblech 2 sind zu diesem Zweck entsprechende Schraublöcher vorgesehen. Mittels einer weiteren Schraube 7 und Gewindehülse 8 wird die erste Leiterplatte 41 und somit das ganze Automatisierungsmodul an der Anschlussplatte 2 befestigt.

An der Vorderseite der Anschlussplatte 2 ist eine Frontplatte 1 angeschraubt. Die Frontplatte 1 weist Öffnungen 11 auf, in welchen Tasten 9 eingesetzt sind. Mit den Tasten 9 können die Benutzer unterschiedliche Funktionen des Automatisierungsmoduls anwählen, wie zum Beispiel die Beleuchtung ein- und ausschalten.

Das in der Figur 3 gezeigte Gehäuse 3, welches vorteilhaft aus einem Kunststoff hergestellt ist, wird durch die achteckige Seitenwand 31 gebildet und erhält dadurch seine achteckige Form. Die durch das Gehäuse 3 hindurchgehende Gehäuseöffnung 313 definiert dabei eine obere Gehäuseöffnung 314 und eine untere Gehäuseöffnung 315, so dass das Gehäuse 3 im Wesentlichen die Form eines beidseitig offenen, achteckigen Rohrs aufweist. Im Bereich ihrer Vorderkante weist die Seitenwand 31 drei nach vorne hin offene Ausnehmungen 312 auf, welche für die Befestigung des Anschlussblechs 2 sowie die Platzierung der oberen, mittleren Taste 9 dienen.

Im Bereich ihrer Oberkante weist die Seitenwand 31 des Gehäuses 3 zudem Öffnungen 311 auf, welche derart angeordnet sind, dass sie beim bestimmungsgemässen Gebrauch auf der Höhe zwischen dem Anschlussblech 2 und der ersten Leiterplatte 41 angeordnet sind. Die Öffnungen 311 dienen als Kabeldurchführung zur Leiterplatte 41, um das Automatisierungsmodul zum Beispiel mit einem Datenbus, einer Speisung für den Kleinspannungsbereich 4 und/oder einem HLK (Heizung, Lüftung, Klima)-Kabel zu verbinden.

Auf einer Unterseite des Gehäuses 3, im Bereich ihrer Unterkante, weist die Seitenwand 31 eine Nut 316 auf, welche sich auf einer Innenseite des Gehäuses 3 entlang der Umfangsrichtung des Gehäuses 3 erstreckt und eine Aufnahme für die dritte Leiterplatte 61 bildet. Die Nut 316 ist radial nach innen sowie nach unten hin offen ausgebildet. Wie insbesondere aus Figur 2 hervorgeht, weist die dritte Leiterplatte 61 einen Durchmesser auf, welcher grösser ist als derjenige der anderen Platten 41, 42, 5. Der dadurch entstehende, im Vergleich zu den Leiterplatten 41, 42, 5 überstehende Bereich der dritten Leiterplatte 61 dient zum Einsetzen der dritten Leiterplatte 61 in die Nut 316. Weiter entspricht die Ausnehmung der Nut 316 entlang einer Längsrichtung, welche sich senkrecht zu den Ebenen der Leiterplatten erstreckt, im Wesentlichen der Dicke der dritten Leiterplatte 61, so dass der grössere Bereich der dritten Leiterplatte 61 vollständig in der Nut 316 aufgenommen wird. Die Nut 316 ermöglicht eine passgenaue Aufnahme der dritten Leiterplatte 61 im Gehäuse 3, wodurch das Gehäuse 3 im Bereich seiner unteren Gehäuseöffnung 315 abgeschlossen und gegenüber dem Anschlussblech 2, aufgrund der mittels der Schrauben 7 und Gewindehülsen 8 miteinander verbundenen Platten 5, 41 und 42, festgeklemmt wird.

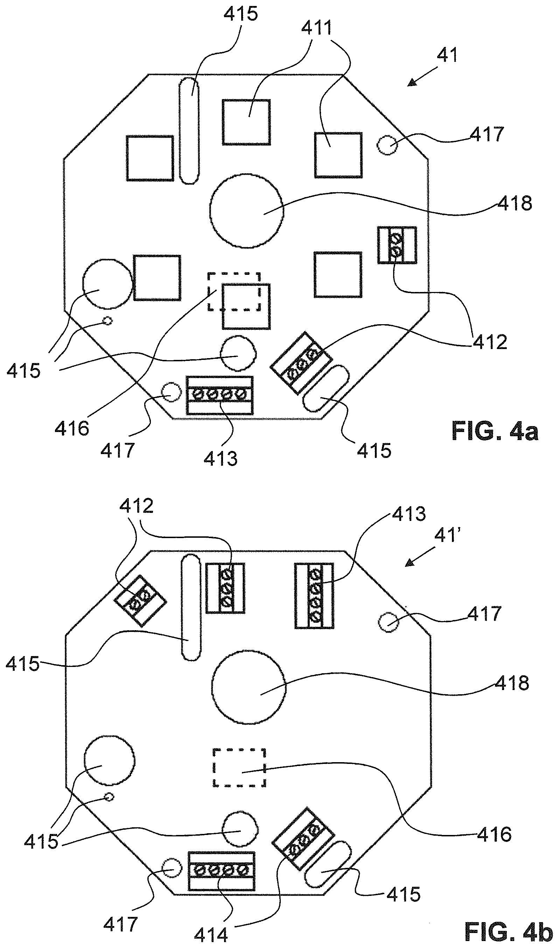

Die Figuren 4a bis 7 zeigen die erste Leiterplatte 41 bzw. 41', die zweite Leiterplatte 42, die Isolationsplatte 5 und die dritte Leiterplatte 61 getrennt voneinander, jeweils in einer Draufsicht von vorne. Elektronische Komponenten, welche auf der Vorderseite einer Platte 41, 42 bzw. 61 angebracht sind, sind in diesen Figuren jeweils mit durchgezogenen Linien dargestellt. Auf der Rückseite angeordnete Komponenten sind jeweils mit gestrichelten Linien gezeichnet.

Die Figur 4a zeigt eine erste Ausführungsform der ersten Leiterplatte 41. Bei dieser Ausführungsform sind auf der Vorderseite der ersten Leiterplatte 41 Tastschalter 411 angebracht. Die Tastschalter 411 sind jeweils unmittelbar hinter den Tasten 9 angeordnet, so dass die Tastschalter 411 mittels Drücken der Tasten 9 bedient werden können, um unterschiedliche Funktionen oder Zustände des Automatisierungsmoduls auszuwählen. Auf der ersten Leiterplatte 41 können zudem LED's als Hintergrundbeleuchtung verwendet werden, um die oberhalb der Tastschalter 411 liegenden Tasten 9 in einer beliebigen Farbe und Helligkeit zu beleuchten. Dadurch können verschiedene Designansprüche erfüllt werden. Auch können die verschiedenen Tasten 9 selbst mit beliebigen Symbolen bedruckt oder z. B. auch geprägt etc. sein, um eine gute Übersicht der Funktionalität zu gewährleisten.

Die erste Leiterplatte 41 weist auf ihrer Vorderseite zudem zwei HLK-Anschlussklemmen 412 auf, um zur Vernetzung mit dem HLK-System entsprechende elektrische Anschlüsse zu ermöglichen. Beispielsweise ist auch der Anschluss eines oder mehrerer in einer benachbarten Unterputzdose untergebrachten Temperatur-, Feuchte- und/oder CO₂-Fühler an eine der HLK-Anschlussklemmen 412 möglich.

Des Weiteren ist auf der Vorderseite der ersten Leiterplatte 41 eine Bus-Anschlussklemme 413 angeordnet, welche zum Anschliessen des Automatisierungsmoduls an einen Datenbus, zum Beispiel in Form eines mehradrigen Kabels, dient. Mit einem an die Bus-Anschlussklemme 413 angeschlossenen Datenbus können mehrere Automatisierungsmodule, welche insbesondere in unterschiedlichen Räumen positioniert sein können, miteinander vernetzt werden. Die Anschlussklemme 413 kann zudem zum Anschliessen einer Niedervoltspeisung zur Energieversorgung des Kleinspannungsbereichs 4 dienen. Die Speisung kann zum Beispiel mittels desselben Kabels erfolgen, welches auch den Datenbus zur Vernetzung mehrerer Automatisierungsmodule bildet. Aufgrund der konsequenten Trennung der elektronischen Komponenten in einen Grossspannungs- und einen Kleinspannungsbereich kann der Stromverbrauch des Automatisierungsmoduls insgesamt minimiert werden (ca. 0.3 W pro Automatisierungsmodul bei der vorliegenden Ausführungsform). Als Kommunikationsprotokoll für den Datenbus wird bevorzugt das Modbus RTU-Protokoll verwendet.

Auf der Rückseite der ersten Leiterplatte 41 ist ein mehradriger Verbindungsstecker 416 angebracht, welcher zum Herstellen von elektrischen Verbindungen mit der zweiten Leiterplatte 42 dient.

Die erste Leiterplatte 41 weist ausserdem zwei längliche und zwei kreisrunde Zugangsöffnungen 415, zwei Schraublöcher 417 und eine kreisrunde Aussparung 418 auf. Die beiden länglichen Zugangsöffnungen 415 ermöglichen von der Vorderseite des in eine Unterputzdose eingesetzten Automatisierungsmoduls her einen Zugang zu den auf der zweiten Leiterplatte 42 angeordneten Programmier- und Serviceschnittstellen 423 und 424. Die beiden kreisrunden Zugangsöffnungen 415 dienen als Zugang zu einem direkt dahinter auf der zweiten Leiterplatte 42 angeordneten HEX-Schalter 426 einerseits und als Sichtfenster für eine ebenfalls auf der zweiten Leiterplatte 42 angeordnete Leuchtdiode 425. Die zwei Schraublöcher 417 dienen zur Herstellung von Schraubverbindungen mit der zweiten Leiterplatte 42. Die Aussparung 418 schafft Platz für eine in den Figuren nicht gezeigte Schraube, welche zur Befestigung der Frontplatte 1 am Anschlussblech 2 dient.

In der Figur 4b ist eine erste Leiterplatte 41' gemäss einer alternativen Ausführungsform gezeigt. Die Leiterplatte 41' unterscheidet sich von der in der Figur 4a gezeigten Leiterplatte 41 dadurch, dass sie anstatt Tastschalter 411 Taster-Anschlussklemmen 414 aufweist. An die Taster-Anschlussklemmen 414 können zum Beispiel ein oder mehrere Taster angeschlossen werden. Diese externen Taster können auch auf einer weiteren Leiterplatte angebracht sein, welche sich in einer anderen Unterputzdose befindet. Es können aber auch die normalen (eventuell schon bestehenden) Taster für Licht resp. Rollläden/Storen verwendet werden, welche ebenfalls in einer anderen Unterputzdose platziert werden können. Auch denkbar wäre das Anschliessen eines Funkempfängers an die Taster-Anschlussklemmen 414 oder an die Serviceschnittstelle 424. Der Funkempfänger könnte zum Empfang von Tastensignalen eines entfernt vom Automatisierungsmodul angeordneten Tastenmoduls dienen. Das zusätzliche Tastenmodul wäre in diesem Fall mit einem entsprechenden Funksender ausgestattet.

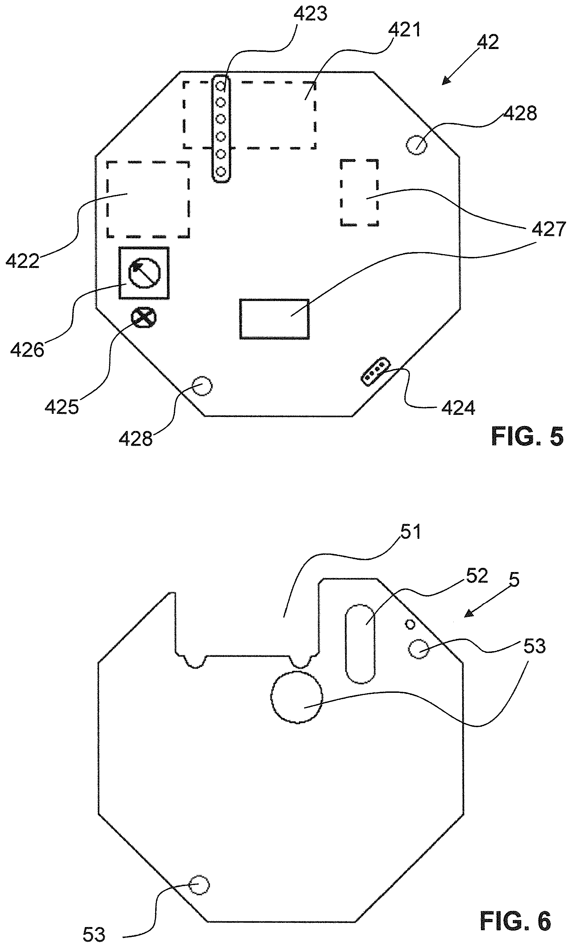

Die Ausgestaltung der zweiten Leiterplatte 42 ist aus der Figur 5 ersichtlich. Auf der Rückseite der Leiterplatte 42 ist ein induktiver Stromsensor 421 angebracht. Der Stromsensor 421, welcher auch in den Figuren 1 und 2 zu sehen ist, weist eine eigene elektrische Isolierung auf und stellt deshalb in der vorliegenden Ausführungsform neben der elektrischen Verbindung 427, 613 die einzige elektronische Komponente dar, welche durch die Isolationsplatte 5 hindurchragt. Der Stromsensor 421 umschliesst eine Durchgangsöffnung, durch welche hindurch das Stromversorgungskabel des jeweiligen Automatisierungsmoduls geführt werden kann zur Erfassung des gesamten wie auch der einzelnen Stromwerte der an das Automatisierungsmodul angeschlossenen Verbraucher. Die an der dritten Leiterplatte 61 angebrachten Aktoren 611 werden durch dieses Stromversorgungskabel mit Spannung versorgt.

Der Stromwert eines einzelnen elektrischen Verbrauchers wird ermittelt, indem die Differenz des jeweiligen eingependelten Wertes des gesamten Stromes vor und nach dem Schalten eines Aktors 611 gebildet wird. Beim Ausschalten eines Aktors wird der jeweilige Stromwert wieder auf 0 zurückgesetzt, sodass sich auch allfällige Offsets und Drifts der Strommessung wieder automatisch kompensieren.

Somit kann auf relativ einfache Weise der detaillierte Energieverbrauch eines gesamten Gebäudes auf Knopfdruck ermitteln werden, wenn die Automatisierungsmodule entsprechend installiert und miteinander vernetzt werden.

Auf der Rückseite der zweiten Leiterplatte 42 ist zudem ein Prozessor 422 angebracht, welcher eine Steuereinheit bildet und zur Ansteuerung der Aktoren 611 dient. Ausserdem kann an der zweiten Leiterplatte 42 ein Speicherchip (in den Figuren nicht gezeigt) angebracht sein zum Beispiel für den Fall, dass der Prozessor selbst über zu wenig internen Speicher verfügt. Der Speicher dient zur Speicherung von unterschiedlichen möglichen und aktuellen Zuständen des Automatisierungsmoduls. Im Speicher können Zustände nicht nur des eigenen Automatisierungsmoduls, sondern auch von weiteren, mit diesem vernetzten Automatisierungsmodulen gespeichert werden. Auch die von den Tastschaltern 411 sowie von den Sensoren und dem Datenbus via die Anschlussklemmen 412, 413, 414 zuletzt empfangenen Signale können im Speicherchip abgespeichert werden. Des Weiteren kann im Speicher die Funktionsbelegung der Tastschalter 411 definiert sein. Vorteilhaft ist die im Speicher gespeicherte Information zum Beispiel via die Programmierschnittstelle 423 oder die Bus-Anschlussklemme 413 mittels entsprechenden Befehlen veränderbar, so dass die Funktion des Automatisierungsmoduls von einer sachkundigen Person oder dem Endbenutzer jederzeit angepasst werden kann.

Auf der Vorderseite der zweiten Leiterplatte 42 ist eine Programmierschnittstelle 423 sowie eine Serviceschnittstelle 424 angeordnet, welche von einer sachkundigen Person benutzt werden können, um das Automatisierungsmodul mittels entsprechender Umprogrammierung an die aktuellen Bedürfnisse anzupassen und/oder um daran Servicearbeiten vorzunehmen. Ebenfalls für diese Zwecke ist ein HEX-Schalter 426 auf der Vorderseite der zweiten Leiterplatte 42 angebracht. Eine LED-Leuchtdiode 425 dient als Statusleuchte, um den Zustand des Automatisierungsmoduls anzugeben. Weitere elektronische Komponenten 429 können auf der Vorder- oder der Rückseite der zweiten Leiterplatte 42 vorgesehen sein.

Auf der Vorder- und der Rückseite der zweiten Leiterplatte 42 sind jeweils mehradrige Verbindungsbuchsen 427 angeordnet, um elektrische Steckverbindungen mit der ersten Leiterplatte 41 bzw. 41' und der dritten Leiterplatte 61 herstellen zu können.

In der zweiten Leiterplatte 42 ausgebildete Schraublöcher 428 dienen zum Hindurchführen von Schrauben 7, um die erste bzw. dritte Leiterplatte 41, 41' und 61 sowie die Isolationsplatte 5 an der zweiten Leiterplatte 42 festzuschrauben.

Die in der Figur 6 gezeigte Isolationsplatte 5 ist aus einem elektrisch isolierenden Material, wie zum Beispiel Epoxy FR4 oder Vetronit®, hergestellt. Um die entsprechend geforderten Normen zu erfüllen, sollten die verwendeten Isolationsmaterialien UL-gelistet und nach der Klasse UL94 V-0 geprüft sein. Die Isolationsplatte 5 weist eine zur Seite hin offene Aussparung 51 auf, welche zum Hindurchführen des Stromsensors 421 dient. Eine in der Isolationsplatte 5 vorhandene Durchgangsöffnung 52 dient zum Hindurchführen einer elektrischen Steckverbindung 427, 613 zwischen der zweiten und der dritten Leiterplatte 42, 61. Schraublöcher 53 sind ausserdem in der Isolationsplatte 5 vorhanden, um diese an der zweiten Leiterplatte 42 bzw. der dritten Leiterplatte 61 zu befestigen.

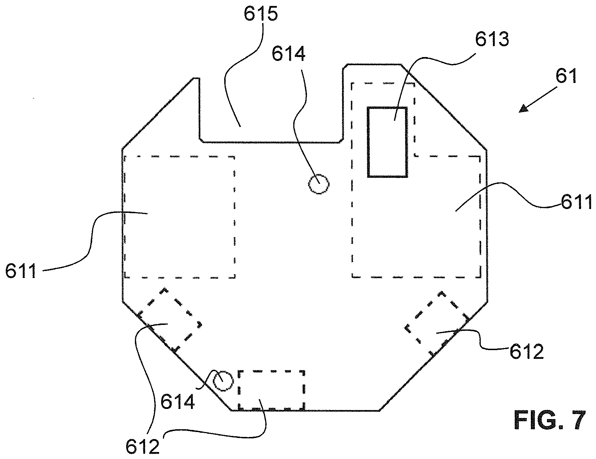

Die Figur 7 zeigt die im Grossspannungsbereich 6 angeordnete dritte Leiterplatte 61. Um ein kompaktes Automatisierungsmodul zu erreichen, werden vorteilhaft nur wenige und vor allem flache elektronische Komponenten an der dritten Leiterplatte 61 nebst dem Verbindungsstecker 613 auf derjenigen Leiterplattenseite angebracht, welche der Isolationsplatte 5 zugewandt ist. Eine Vielzahl von Relaisschaltern 611 ist auf der Rückseite der dritten Leiterplatte 61 angeordnet. Die Relaisschalter 611 bilden die Aktoren des Automatisierungsmoduls, welche zum Schalten der daran angeschlossenen Verbraucher dienen, wie zum Beispiel Lampen oder Rolläden. Zum Anschliessen dieser Verbraucher am Automatisierungsmodul sind auf der Rückseite der dritten Leiterplatte 61 mehrere Anschlussklemmen 612 angeordnet. Die Relaisschalter 611 können beispielsweise zum Schalten von Strömen in der Höhe von 5A, 10A oder 16A ausgelegt sein.

Eine seitlich offene, rechteckige Aussparung 615 dient zum Hindurchführen des Stromsensors 421. Durch die auf der Höhe der Anschlussklemmen 612 angeordnete Durchgangsöffnung des Stromsensors 421 hindurch kann das Stromversorgungskabel des jeweiligen Automatisierungsmoduls geführt werden, so dass der Stromverbrauch der Verbraucher vom Automatisierungsmodul erfassbar ist. Schraublöcher 614 dienen zur Befestigung der dritten Leiterplatte 61 an der Isolationsplatte 5 und an der zweiten Leiterplatte 42.

Das einzelne, in den Figuren 1 bis 7 gezeigte Automationsmodul stellt üblicherweise einen Teil einer Gebäudeautomationsvorrichtung dar, welche eine Vielzahl von weiteren derartigen Automationsmodulen aufweisen kann, die in der Regel via einen Datenbus miteinander verbunden sind. Teil der Gebäudeautomationsvorrichtung kann zudem, muss aber nicht, eine Zentraleinheit sein, welche die Funktion einer zentralen, übergeordneten Steuerung der verschiedenen Automationsmodule übernehmen kann. Die Zentraleinheit kann zusätzlich oder alternativ auch dafür vorgesehen sein, um eine Wireless- oder GSM-Verbindung mit einem oder mehreren Steuergeräten herzustellen. Beim Steuergerät kann es sich insbesondere um ein Smartphone oder einen Tablet-Computer handeln. Selbstverständlich ist die hier beschriebene Erfindung nicht auf die erwähnten Ausführungsformen beschränkt und eine Vielzahl von Abwandlungen ist möglich. Anstelle eines zusätzlichen Tastenmoduls könnte an den Anschlussklemmen 414 der Leiterplatte 41' oder an der Serviceschnittstelle 424 der zweiten Leiterplatte 42 auch ein Touchscreen oder eine beliebig anders ausgebildete Benutzerschnittstelle am Automationsmodul angeschlossen sein. Eine Vielzahl weiterer Abwandlungen ist im Rahmen des von den beiliegenden Ansprüchen definierten Schutzumfangs denkbar.

**BEZUGSZEICHENLISTE**

| | | | |
|---|---|---|---|
| 1 | Frontplatte | 421 | Stromsensor |
| 11 | Öffnung | 422 | Prozessor |
| | | 423 | Programmierschnittstelle |
| 2 | Anschlussblech | 424 | Serviceschnittstelle |
| | | 425 | Leuchtdiode |
| 3 | Gehäuse | 426 | HEX-Schalter |
| 31 | Seitenwand | 427 | Verbindungsbuchse |
| 311 | Öffnung | 428 | Schraubloch |
| 312 | Ausnehmung | 429 | Elektronische Komponenten |
| 313 | Gehäuseöffnung | | |
| 314 | obere Gehäuseöffnung | 5 | Isolationsplatte |
| 315 | untere Gehäuseöffnung | 51 | Aussparung |
| 316 | Nut | 52 | Durchgangsöffnung |
| | | 53 | Schraubloch |
| 4 | Kleinspannungsbereich | | |
| | | 6 | Grossspannungsbereich |
| 41, 41' | Erste Leiterplatte | | |
| 411 | Tastschalter | 61 | Dritte Leiterplatte |
| 412 | HLK-Anschlussklemme | 611 | Relaisschalter |
| 413 | Bus-Anschlussklemme | 612 | Anschlussklemme |
| 414 | Taster-Anschlussklemme | 613 | Verbindungsstecker |
| 415 | Zugangsöffnung | 614 | Schraubloch |
| 416 | Verbindungsstecker | 615 | Aussparung |
| 417 | Schraubloch | | |
| 418 | Aussparung | 7 | Schraube |
| | | 8 | Gewindehülse |
| 42 | Zweite Leiterplatte | 9 | Taste |

## Patentansprüche

1. Automatisierungsmodul für die Gebäudeautomation, welches für den zumindest teilweisen Unterputzeinbau in einer Hauswand ausgelegt ist, mit einem Grossspannungsbereich (6) und einem Kleinspannungsbereich (4) sowie aufweisend
einen Isolationsbereich (5) zur Trennung des Grossspannungsbereichs (6) vom Kleinspannungsbereich (4);
eine erste Leiterplatte (41, 41') mit zumindest einer Eingabe-Schnittstelle (411, 414);
eine zweite Leiterplatte (42) mit zumindest einer Steuereinheit (422); und eine dritte Leiterplatte (61) mit zumindest einem Schaltelement (611); wobei die erste, zweite und dritte Leiterplatte (41, 41'; 42; 61) sowie der Isolationsbereich (5) schichtweise übereinander angeordnet sind,
wobei der Isolationsbereich in Form einer Isolationsplatte (5) ausgebildet ist, und
wobei die erste Leiterplatte (41, 41') und die zweite Leiterplatte (42) im Kleinspannungsbereich (4) angeordnet sind und die dritte Leiterplatte (61) im Grossspannungsbereich (6).

2. Automatisierungsmodul nach Anspruch 1, wobei der Isolationsbereich (5) zwischen der zweiten und der dritten Leiterplatte (42; 61) angeordnet ist.

3. Automatisierungsmodul nach Anspruch 2, wobei die zweite und die dritte Leiterplatte (42; 61) jeweils elektronische Komponenten (425, 426, 429; 611) aufweisen, und wobei diese elektronischen Komponenten (425, 426, 429; 611) zu einem Grossteil auf den vom Isolationsbereich (5) abgewandten Seiten der zweiten und dritten Leiterplatte (42; 61) angeordnet sind.

4. Automatisierungsmodul nach einem der vorhergehenden Ansprüche, wobei an der ersten oder der zweiten Leiterplatte (41, 41'; 42) ein insbesondere induktiver Stromsensor (421) angebracht ist, und wobei der Isolationsbereich vorzugsweise eine Isolationsplatte (5) umfasst, welche eine Aussparung (51) aufweist, durch welche der Stromsensor (421) hindurchragt.

5. Automatisierungsmodul nach einem der vorhergehenden Ansprüche, wobei auf der zweiten Leiterplatte (42) zumindest eine Service- und/oder Programmierschnittstelle (424, 423) vorgesehen ist, und wobei die erste Leiterplatte (41, 41') zumindest eine durchgehende Zugangsöffnung (415) aufweist, welche einen Zugang zur Service- bzw. Programmierschnittstelle (424, 423) ermöglicht.

6. Automatisierungsmodul nach einem der vorhergehenden Ansprüche, wobei die erste, zweite und dritte Leiterplatte (41, 41'; 42; 61) jeweils mittels entsprechend vorgesehener elektrischer Steckverbindungen (416, 427, 613) miteinander verbunden sind.

7. Automatisierungsmodul nach Anspruch 6, wobei die erste, zweite und dritte Leiterplatte jeweils zerstörungsfrei mittels Lösen der elektrischen Steckverbindungen voneinander trennbar sind.

8. Automatisierungsmodul nach einem der vorhergehenden Ansprüche, wobei auf der ersten, zweiten oder dritten Leiterplatte (41, 41'; 42; 61), bevorzugt auf der ersten Leiterplatte (41, 41'), ein Anschluss (413) für einen Datenbus vorgesehen ist, welcher zur Vernetzung von mehreren Automatisierungsmodulen dient.

9. Automatisierungsmodul nach einem der vorhergehenden Ansprüche, wobei die erste, zweite und dritte Leiterplatte (41, 41'; 42; 61) jeweils im Wesentlichen eine achteckige Form haben.

10. Automatisierungsmodul nach einem der vorhergehenden Ansprüche, wobei ein Gehäuse (3) mit einer durchgehenden Gehäuseöffnung (313) die erste, zweite und dritte Leiterplatte (41, 41'; 42; 61) seitlich umgibt, und wobei das Gehäuse (3) vorzugsweise eine achteckige Form hat.

11. Automatisierungsmodul nach einem der vorhergehenden Ansprüche, wobei die dritte Leiterplatte (61) einen grösseren Durchmesser aufweist als die erste und zweite Leiterplatte (41, 41'; 42).

12. Automatisierungsmodul nach Anspruch 11, wobei das Gehäuse (3) im Bereich der dritten Leiterplatte (61) eine Nut (316) aufweist, welche sich auf einer Innenseite des Gehäuses (3) entlang einer Umfangsrichtung des Gehäuses (3) erstreckt, und wobei die Nut (316) zur Aufnahme der dritten Leiterplatte (61) dient.

13. Gebäudeautomationsvorrichtung aufweisend zumindest ein Automatisierungsmodul nach einem der vorhergehenden Ansprüche.

## Claims

1. An automation module for building automation, which is designed for at least partial in-wall installation in a house wall, with a high voltage region (6) and a low voltage region (4) as well as comprising
an insulation region (5) for separating the high voltage region (6) from the low voltage region (4);
a first printed circuit board (41, 41') with at least one input interface (411, 414);
a second printed circuit board (42) with at least one control unit (422); and
a third printed circuit board (61) with at least one switching element (611);
wherein the first, second and third printed circuit boards (41, 41'; 42; 61) as well as the insulation region (5) are arranged one above the other in layers,
wherein the insulation region is in the form of an insulation plate (5), and
wherein the first printed circuit board (41, 41') and the second printed circuit board (42) are arranged in the low-voltage region (4) and the third printed circuit board (61) is arranged in the high-voltage region (6).

2. The automation module according to claim 1, wherein the insulation region (5) is arranged between the second and the third printed circuit board (42; 61).

3. The automation module according to claim 2, wherein the second and the third printed circuit board (42; 61) each comprise electronic components (425, 426, 429; 611), and wherein these electronic components (425, 426, 429; 611) are arranged to a large part on the sides of the second and third printed circuit board (42; 61) facing away from the insulation region (5).

4. The automation module according to one of the preceding claims, wherein a current sensor (421), in particular an inductive current sensor, is attached to the first or the second printed circuit board (41, 41'; 42), and wherein the insulation region preferably includes an insulation plate (5) which has a recess (51) through which the current sensor (421) projects.

5. The automation module according to one of the preceding claims, wherein at least one service and/or programming interface (424, 423) is provided on the second printed circuit board (42), and wherein the first printed circuit board (41, 41') comprises at least one through-going access opening (415) which allows access to the service and/or programming interface (424, 423).

6. The automation module according to any one of the preceding claims, wherein the first, second and third printed circuit boards (41, 41'; 42; 61) are each connected to one another by means of correspondingly provided electrical plug connections (416, 427, 613).

7. The automation module according to claim 6, wherein the first, second and third printed circuit boards can each be separated from one another in a non-destructive manner by releasing the electrical plug connections.

8. The automation module according to one of the preceding claims, wherein a connector (413) for a data bus is provided on the first, second or third printed circuit board (41, 41'; 42; 61), preferably on the first printed circuit board (41, 41'), which connector serves for networking a plurality of automation modules.

9. The automation module according to any one of the preceding claims, wherein the first, second and third printed circuit boards (41, 41'; 42; 61) each have a substantially octagonal shape.

10. The automation module according to one of the preceding claims, wherein a housing (3) with a through-going housing opening (313) laterally surrounds the first, second and third printed circuit boards (41, 41'; 42; 61), and wherein the housing (3) preferably has an octagonal shape.

11. The automation module according to any one of the preceding claims, wherein the third printed circuit board (61) has a larger diameter than the first and second printed circuit boards (41, 41'; 42).

12. The automation module according to claim 11, wherein the housing (3) comprises a groove (316) in the region of the third printed circuit board (61), which groove extends on an inner side of the housing (3) along a circumferential direction of the housing (3), and wherein the groove (316) serves to receive the third printed circuit board (61).

13. A building automation device comprising at least one automation module according to any one of the preceding claims.

## Revendications

1. Module d'automatisation pour l'automatisation du bâtiment, qui est conçu pour un encastrement au moins partiel dans un mur d'une maison, avec une zone haute tension (6) et une zone basse tension (4) ainsi qu'ayant
une zone d'isolation (5) pour séparer la zone haute tension (6) de la zone basse tension (4) ;
une première carte de circuit imprimé (41, 41') avec au moins une interface d'entrée (411, 414);
une seconde carte de circuit imprimé (42) avec au moins une unité de commande (422); et
une troisième carte de circuit imprimé (61) avec au moins un élément de commutation (611) ;
dans lequel les première, deuxième et troisième cartes de circuits imprimés (41, 41'; 42; 61) ainsi que la zone d'isolation (5) sont disposés en couches l'une au-dessus de l'autre,
dans lequel la zone d'isolation est réalisée sous forme d'une plaque d'isolation (5), et
dans lequel la première carte de circuit imprimé (41, 41') et la seconde carte de circuit imprimé (42) sont disposées dans la zone basse tension (4) et la troisième carte de circuit imprimé (61) est disposée dans la zone haute tension (6).

2. Module d'automatisation selon la revendication 1, dans lequel la zone d'isolation (5) est disposée entre le deuxième et troisième circuit imprimé (42; 61).

3. Module d'automatisation selon la revendication 2, dans lequel le deuxième et troisième circuit imprimé (42 ; 61) comportent chacun des composants électroniques (425, 426, 429 ; 611), et dans lequel ces composants électroniques (425, 426, 429; 611) sont en grande partie disposés sur les faces de la zone d'isolation (5) éloignées de la deuxième et de la troisième carte de circuit imprimé (42; 61).

4. Module d'automatisation selon l'une des revendications précédentes, dans lequel un capteur de courant (421), en particulier inductif, est fixé sur la première ou la deuxième carte de circuit imprimé (41, 41'; 42), et dans lequel la zone d'isolation comprend de préférence une plaque d'isolation (5) qui présente un évidement (51) à travers lequel le capteur de courant (421) fait saillie.

5. Module d'automatisation selon l'une des revendications précédentes, dans lequel au moins une interface de service et/ou de programmation (424, 423) est prévue sur la deuxième carte de circuit imprimé (42), et dans lequel la première carte de circuit imprimé (41, 41') présente au moins une ouverture de passage d'accès (415) qui permet d'accéder à l'interface de service respectivement de programmation (424, 423).

6. Module d'automatisation selon l'une des revendications précédentes, dans lequel les première, deuxième et troisième cartes de circuits imprimés (41, 41'; 42; 61) sont chacune reliées entre elles au moyen de connecteurs électriques prévus en conséquence (416, 427, 613).

7. Module d'automatisation selon la revendication 6, dans lequel les première, deuxième et troisième cartes de circuits imprimés peuvent chacune être séparées l'une de l'autre de manière non destructive en libérant les connexions électriques à fiches.

8. Module d'automatisation selon l'une des revendications précédentes, dans lequel une connexion (413) pour un bus de données est prévue sur la première, la deuxième ou la troisième carte de circuit imprimé (41, 41'; 42; 61), de préférence sur la première carte de circuit imprimé (41, 41'), lequel bus sert à l'interconnexion de plusieurs modules d'automatisation.

9. Module d'automatisation selon l'une des revendications précédentes, dans lequel les première, deuxième et troisième cartes de circuits imprimés (41, 41'; 42; 61) ont chacune une forme sensiblement octogonale.

10. Module d'automatisation selon l'une des revendications précédentes, dans lequel un boîtier (3) entoure latéralement les première, deuxième et troisième circuits imprimés (41, 41' ; 42 ; 61) avec une ouverture de boîtier continue (313 et dans lequel le boîtier (3) a de préférence une forme octogonale.

11. Module d'automatisation selon l'une des revendications précédentes, dans lequel le troisième circuit imprimé (61) a un diamètre plus grand que les premier et deuxième circuits imprimés (41, 41' ; 42).

12. Module d'automatisation selon la revendication 11, dans lequel le boîtier (3) présente une rainure (316) dans la région de la troisième carte de circuit imprimé (61) qui s'étend à l'intérieur du boîtier (3) le long d'une direction circonférentielle du boîtier (3), et dans lequel la rainure (316)) est utilisée pour la réception de la troisième carte de circuit imprimé (61).

13. Dispositif d'automatisation du bâtiment comprenant au moins un module d'automatisation selon l'une des revendications précédentes.
